# EUROPEAN PATENT APPLICATION

(11) **EP 4 307 394 A1**
(43) Date of publication of application: **17.01.2024**
(21) Application number: 21940511.5
(22) Date of filing: 12.11.2021
(51) Int. Cl.: H01L 31/0216, H01L 31/068, H01L 31/18

(54) **PERC BATTERY BACK PASSIVATION STRUCTURE, AND PERC BATTERY AND PREPARATION METHOD THEREFOR**

(30) Priority: 18.05.2021 CN 202110538791; 18.05.2021 CN 202121059479 U
(71) Applicant: Hengdian Group DMEGC Magnetics Co., Ltd., Jinhua, Zhejiang 322118 (CN)
(72) Inventor: FANG, Chaoyan, Jinhua, Zhejiang 322118 (CN); HE, Yue, Jinhua, Zhejiang 322118 (CN); GUO, Shuai, Jinhua, Zhejiang 322118 (CN); REN, Hailiang, Jinhua, Zhejiang 322118 (CN); REN, Yong, Jinhua, Zhejiang 322118 (CN); CHEN, Deshuang, Jinhua, Zhejiang 322118 (CN); XU, Jun, Jinhua, Zhejiang 322118 (CN); JIN, Zhihong, Jinhua, Zhejiang 322118 (CN)
(74) Representative: Cabinet Beaumont
(86) International application number: PCT/CN2021/130303
(87) International publication number: WO 2022/242067

(57) **Abstract**

Provided in the present invention are a PERC battery back passivation structure, and a PERC battery and a preparation method therefor. The PERC battery back passivation structure comprises a crystalline silicon oxide layer, which is arranged on the back face of a silicon substrate. Further provided in the present invention are a PERC battery back passivation structure and a PERC battery comprising same. The PERC battery back passivation structure comprises a first crystalline silicon oxide layer, a gallium oxide layer, a second crystalline silicon oxide layer and at least two back-face silicon nitride layers, which are sequentially stacked on the back face of the silicon substrate.

## Description

### TECHNICAL FIELD

The present application belongs to the technical field of photovoltaic cells, and relates to a rear passivation structure of a PERC cell, a PERC cell and a preparation method therefor.

### BACKGROUND

PERC cell, the technology of passivated emitter and rear cell, which originated in the 1980s, has improved conversion efficiency by overlaying a passivation layer on the rear side of the conventional cell. A general process flow of the PERC cell has the following steps: texturization → diffusion → SE laser → oxidation → etching (phosphosilicate glass (PSG) removal) —> annealing —> rear film —> front film —> laser grooving —> screen printing —> sintering —> light injection or electrical injection —> test and sorting. The film coating process is an extremely important link in the PERC cell production line. In the production process, the cell sheet needs to be coated with an anti-reflection film on the front side to reduce light reflection and enhance light absorption. A passivation film is coated on the rear side. Generally, the passivation film can passivate the dangling bonds on the silicon surface to reduce the recombination rate of the surface, thereby achieving surface passivation or bulk passivation. Moreover, the high refractive index of passivation film can enhance the reflectivity of the rear side to further improve cell efficiency. It can be said that the quality of the passivation film directly affects the performance of the solar cell.

Silicon dioxide is a good passivation material. The SiO₂ thin film is mostly grown via thermal oxidation method in the industry, where a silicon wafer is placed in a high-temperature quartz furnace tube, and the SiO₂ thin film is grown on the silicon wafer surface with an oxidizing substance. According to different oxidizing atmospheres, the thermal oxidation can be divided into dry oxidation, water vapor oxidation and wet oxidation. The oxide layer can effectively reduce the interface defect density. Chemical passivation exerts a chiefly effect on the Si-SiO₂ interface by saturating dangling bonds. The Si-SiO₂ interface has some fixed positive charges with a charge density at 1010 cm⁻² level, and the amount of charges is related to annealing conditions and may be negligible compared with the fixed negative charges (1012 cm⁻²) of AlOₓ, that is, the positive charges carried by the SiOₓ passivation film have no important influence on the field passivation effect of the AlOₓ. However, the thermal oxidation growth has a defect of slow growth speed, and cannot give much thickness.

CN105470349A discloses a PERC solar cell and a preparation method therefor. The PERC solar cell includes a silicon wafer, a silicon dioxide layer and a silver layer located on an upper surface of the silicon wafer, a front-side silicon nitride passivation layer located on an upper surface of the silicon dioxide layer, an aluminum oxide passivation layer located on a lower surface of the silicon wafer and a rear-side silicon nitride passivation layer located on a lower surface of the aluminum oxide passivation layer, where a plurality of openings are spaced apart from each other on the rear-side silicon nitride passivation layer, and the openings are filled with an aluminum layer that forms an aluminum-silicon alloy with the silicon wafer after the aluminum oxide passivation layer is corroded. In this invention, the openings are formed on the rear-side silicon nitride passivation layer in a manner of laser opening, and depths of the openings are controlled at a degree where the rear-side silicon nitride passivation layer is penetrated through while the aluminum oxide passivation layer is not penetrated through. Then, an aluminum paste is printed, and through a sintering process, the aluminum paste corrodes the aluminum oxide passivation layer and forms the aluminum-silicon alloy with the silicon wafer.

CN209515679U discloses a PERC cell, which includes a substrate, a front-side silicon dioxide layer, an anti-reflection layer, a front-side silicon nitride layer, a rear-side passivation layer and a protective structure, where the front-side silicon dioxide layer is disposed on a front side of the substrate, the anti-reflection layer is disposed on a side of the front-side silicon dioxide layer opposite to the substrate, and the front-side silicon nitride layer is disposed on a side of the anti-reflection layer opposite to the front-side silicon dioxide layer.

CN110854240A discloses a PERC cell and a preparation method therefor. The preparation method includes texturization, diffusion, etching, rear-side polishing, annealing, rear-side film coating and front-side film coating. The step of rear-side film coating includes: introducing ozone into a device containing an annealed silicon wafer to perform an oxidation treatment so that a rear-side silicon dioxide layer is formed on the rear side of the silicon wafer; then, continuing to introduce ozone into the same device as an oxygen source, and adding an aluminum source to deposit a rear-side aluminum oxide layer on the rear-side silicon dioxide layer; depositing a rear-side silicon nitride layer on the rear-side aluminum oxide layer.

At present, the commonly used method for depositing a silicon dioxide layer is plasma-enhanced chemical vapor deposition (PECVD). Silicon oxide is deposited by using silane and laughing gas. The PECVD has a relatively fast growth speed and can deposit a thick silicon oxide thin film. However, the silicon oxide thin film has a relatively loose structure and a relatively poor passivation effect.

### SUMMARY

In view of the shortcomings in the existing art, an object of the present application is to provide a rear passivation structure of a PERC cell, a PERC cell and a preparation method therefor. In the present application, traditional amorphous silicon oxide is replaced with crystalline silicon oxide. Since atomic distribution in the crystalline silicon oxide has a long-range order, compared with an amorphous silicon oxide layer, a crystalline silicon oxide layer has a higher compactness and a better passivation effect, and the interface defect density can be as low as 10¹⁰ cm⁻²eV⁻¹, improving the overall performance of the PERC cell.

To achieve this object, the present application adopts the technical solutions below.

In a first aspect, the present application provides a rear passivation structure of a PERC cell. The rear passivation structure of the PERC cell includes a crystalline silicon oxide layer disposed on a rear side of a silicon substrate.

Amorphous silicon oxide is mostly adopted for the silicon oxide layer in the rear passivation structure of the PERC cell. However, the amorphous silicon oxide has relatively weak silicon-hydrogen bonds and relatively poor passivation effect. In the present application, traditional amorphous silicon oxide is replaced with crystalline silicon oxide. The atomic distribution in the amorphous silicon oxide has a certain order, but only a short-range order, while atomic distribution in the crystalline silicon oxide has a long-range order. Therefore, compared with an amorphous silicon oxide layer, the crystalline silicon oxide layer has a higher compactness, a better passivation effect and the interface defect density that can be as low as 10¹⁰ cm⁻²eV⁻¹, improving the overall performance of the PERC cell.

It should be noted that the rear passivation structure as claimed in the present application is part of the structure of the PERC cell, and it should be understood that, within the protection scope limited here, no specific requirements or special limitations are imposed on other structures in the PERC cell. In other words, on the basis of the rear passivation structure limited in the present application, those skilled in the art may make conventional substitutions or inventive improvements to the other structures based on the existing art.

Exemplarily, the present application provides a complete structure of a PERC cell, which includes a silicon substrate, where an emitter, a front-side silicon oxide layer and a front-side silicon nitride layer (the front-side silicon nitride layer may be replaced with a silicon oxynitride layer or a silicon carbide layer) are stacked on a front side of the silicon substrate in sequence, and a front-side electrode is perpendicularly inserted into the front side. A crystalline silicon oxide layer, an aluminum oxide layer and a rear-side silicon nitride layer (the rear-side silicon nitride layer may be replaced with a silicon oxynitride layer or a silicon carbide layer) are stacked on a rear side of the silicon substrate in sequence, and meanwhile, a rear-side electrode is perpendicularly inserted into the rear side. Those skilled in the art may make inventive improvements to the other layers except the crystalline silicon oxide layer, such as improving materials, adding other functional layers or removing one of the layers. Of course, no matter what kind of improvement is made, as long as the rear passivation structure provided in the present application is adopted, the improved PERC cell also falls within the protection scope and the disclosed scope of the present application.

As a preferred technical solution of the present application, the crystalline silicon oxide layer has a thickness of 1-20 nm, which may be, for example, 1 nm, 2 nm, 3 nm, 4 nm, 5 nm, 6 nm, 7 nm, 8 nm, 9 nm, 10 nm, 11 nm, 12 nm, 13 nm, 14 nm, 15 nm, 16 nm, 17 nm, 18 nm, 19 nm or 20 nm. However, the thickness is not limited to the listed values, and other unlisted values within this value range are also applicable.

As a preferred technical solution of the present application, an aluminum oxide layer and a rear-side silicon nitride layer are stacked on a surface of the crystalline silicon oxide layer in sequence.

The aluminum oxide layer has a thickness of 5-10 nm, which may be, for example, 5 nm, 5.5 nm, 6 nm, 6.5 nm, 7 nm, 7.5 nm, 8 nm, 8.5 nm, 9 nm, 9.5 nm or 10 nm. However, the thickness is not limited to the listed values, and other unlisted values within this value range are also applicable.

The rear-side silicon nitride layer has a thickness of 10-200 nm, which may be, for example, 10 nm, 20 nm, 30 nm, 40 nm, 50 nm, 60 nm, 70 nm, 80 nm, 90 nm, 100 nm, 110 nm, 120 nm, 130 nm, 140 nm, 150 nm, 160 nm, 170 nm, 180 nm, 190 nm or 200 nm. However, the thickness is not limited to the listed values, and other unlisted values within this value range are also applicable.

In a second aspect, the present application provides a method for preparing the rear passivation structure of the PERC cell according to the first aspect. The preparation method includes:
depositing an amorphous silicon oxide thin film on the rear side of the silicon substrate, and performing an annealing treatment to transform the amorphous silicon oxide thin film into the crystalline silicon oxide layer.

In the present application, the amorphous silicon oxide thin film is first deposited on the rear side of the silicon substrate. However, the amorphous silicon oxide thin film has a relatively loose structure, the deposited silicon oxide is amorphous, the silicon-hydrogen bond is relatively weak, and the passivation effect is relatively poor. Then, after the annealing treatment, the amorphous silicon oxide is gradually transformed into hydrogen-rich crystalline silicon oxide so that the passivation effect is significantly enhanced. Finally, a relatively thick crystalline silicon oxide layer with relatively good passivation effect is obtained. The interface defect density can be as low as 10¹⁰ cm⁻²eV⁻¹, improving the overall performance of the solar cell.

As a preferred technical solution of the present application, the deposition process of the amorphous silicon oxide thin film specifically includes:
placing the silicon substrate in a film-forming chamber, introducing laughing gas and silane into the film-forming chamber, and with a pressure maintained in the film-forming chamber, performing PECVD to deposit an amorphous silicon oxide thin film on the rear side of the silicon substrate.

In the present application, the rear passivation structure of the monocrystalline PERC cell is prepared through the combination of the PECVD and the thermal oxidation method. Through the PECVD, the silicon oxide layer is first deposited by using silane and laughing gas with the assistance of the plasma. Compared with the thermal oxidation, the silicon oxide layer deposited through the PECVD has a relatively fast growth speed, and the silicon oxide layer can be deposited thick. However, accordingly, the silicon oxide layer has a relatively loose structure, the deposited silicon oxide is amorphous, the silicon-hydrogen bond is relatively weak, and the passivation effect is inferior to that of the silicon oxide layer formed through the thermal oxidation. On this basis, in the present application, the amorphous silicon oxide is gradually transformed into the crystalline silicon oxide through the thermal oxidation method so that the passivation effect is significantly enhanced. Finally, a relatively thick crystalline silicon oxide layer with relatively good passivation effect is obtained. The interface defect density can be as low as 10¹⁰ cm⁻²eV⁻¹, thereby improving the overall performance of the solar cell.

As a preferred technical solution of the present application, the laughing gas is introduced at a flow rate of 4000-6000 sccm, which may be, for example, 4000 sccm, 4200 sccm, 4400 sccm, 4600 sccm, 4800 sccm, 5000 sccm, 5200 sccm, 5400 sccm, 5600 sccm, 5800 sccm or 6000 sccm. However, the flow rate is not limited to the listed values, and other unlisted values within this value range are also applicable.

The silane is introduced at a flow rate of 500-800 sccm, which may be, for example, 500 sccm, 520 sccm, 540 sccm, 560 sccm, 580 sccm, 600 sccm, 620 sccm, 640 sccm, 660 sccm, 680 sccm, 700 sccm, 720 sccm, 740 sccm, 760 sccm, 780 sccm or 800 sccm. However, the flow rate is not limited to the listed values, and other unlisted values within this value range are also applicable.

The pressure in the film-forming chamber is maintained at 1400-1600 Pa, which may be, for example, 1400 Pa, 1420 Pa, 1440 Pa, 1460 Pa, 1480 Pa, 1500 Pa, 1520 Pa, 1540 Pa, 1560 Pa, 1580 Pa or 1600 Pa. However, the pressure is not limited to the listed values, and other unlisted values within this value range are also applicable.

The plasma has a radio frequency power of 6000-10000 W, which may be, for example, 6000 W, 6500 W, 7000 W, 7500 W, 8000 W, 8500 W, 9000 W, 9500 W or 10000 W. However, the radio frequency power is not limited to the listed values, and other unlisted values within this value range are also applicable.

The deposition is performed for 10-300 s, which may be, for example, 10 s, 50 s, 100 s, 150 s, 200 s, 250 s or 300 s. However, the time is not limited to the listed values, and other unlisted values within this value range are also applicable.

As a preferred technical solution of the present application, the annealing process is performed in a hydrogen-rich atmosphere.

The hydrogen-rich atmosphere is a mixed gas including hydrogen, where the hydrogen accounts for 40-80% of a total volume of the mixed gas, which may be, for example, 40%, 45%, 50%, 55%, 60%, 65%, 70%, 75% or 80%. However, the percentage is not limited to the listed values, and other unlisted values within this value range are also applicable.

In the present application, since lots of dangling bonds of silicon atoms (valence bonds not bound to oxygen atoms) exist at the interface between Si and SiO₂, the presence of the dangling bonds can affect the interface defect density, thereby reducing the passivation effect of silicon dioxide layer. Therefore, in the present application, the annealing treatment is performed in the hydrogen-rich atmosphere so that hydrogen atoms enter the interface and form Si-H bonds with the dangling bonds to reduce the presence of the dangling bonds at the interface, reduce the density of state of the Si/SiO₂ interface and improve the passivation effect of the silicon dioxide layer.

The mixed gas further includes nitrogen and/or an inert gas.

As a preferred technical solution of the present application, the annealing is performed at 850-1300 °C, which may be, for example, 850 °C, 900 °C, 950 °C, 1000 °C, 1050 °C, 1100 °C, 1150 °C, 1200 °C, 1250 °C or 1300 °C. However, the temperature is not limited to the listed values, and other unlisted values within this value range are also applicable.

In the present application, the annealing is particularly required to be performed at 850-1300 °C. When the annealing temperature is lower than 850 °C, the temperature cannot reach a crystallization temperature of SiO₂, and when the annealing temperature is higher than 1300 °C, energy consumption is increased, and a degree of thermal damage to a silicon wafer is also increased.

The annealing is performed for 1-20 min, which may be, for example, 1 min, 2 min, 3 min, 4 min, 5 min, 6 min, 7 min, 8 min, 9 min, 10 min, 11 min, 12 min, 13 min, 14 min, 15 min, 16 min, 17 min, 18 min, 19 min or 20 min. However, the time is not limited to the listed values, and other unlisted values within this value range are also applicable.

As a preferred technical solution of the present application, the preparation method further includes: depositing an aluminum oxide layer and a rear-side silicon nitride layer on the surface of the crystalline silicon oxide layer in sequence.

In a third aspect, a PERC cell including the rear passivation structure of the PERC cell according to the first aspect is provided, where the PERC cell includes a silicon substrate, an emitter, a front-side silicon oxide layer and a front-side silicon nitride layer are stacked on a front side of the silicon substrate in sequence, and the rear passivation structure according to the first aspect is disposed on a rear side of the silicon substrate.

The PERC cell further includes a front-side electrode and a rear-side electrode, where the front-side electrode is perpendicularly inserted into the silicon substrate from a front side of the PERC cell, and the rear-side electrode is perpendicularly inserted into the silicon substrate from a rear side of the PERC cell.

It should be noted that a method for preparing the crystalline silicon oxide layer is particularly required to be PECVD and a thermal oxidation method in the present application, but no specific requirements or special limitations are imposed on methods for preparing other layers in the PERC cell. Exemplarily, the present application provides the preparation method below for reference by those skilled in the art, which is, however, not intended to limit the protection scope of the present application:
(1) performing texturization on a surface of a monocrystalline silicon substrate to form a textured surface, and cleaning the monocrystalline silicon substrate after the texturization;
(2) performing phosphorus diffusion on the cleaned silicon substrate to generate PSG on the surface, and then performing laser doping to form a localised heavily doped region on a front side of the silicon substrate to obtain a selective emitter;
(3) etching and removing the remained PSG on the surface of the silicon substrate with an HF aqueous solution;
(4) performing thermal oxidation to deposit a front-side silicon oxide layer on a surface of the selective emitter;
(5) placing the silicon substrate in a film-forming chamber, introducing laughing gas and silane into the film-forming chamber, and performing PECVD to deposit an amorphous silicon oxide thin film on a rear side of the silicon substrate;
(6) then, performing annealing treatment on the silicon substrate in a hydrogen-rich atmosphere, where the hydrogen-rich atmosphere is a mixed gas of nitrogen and/or an inert gas; after the annealing is completed, the amorphous silicon oxide thin film is transformed into a crystalline silicon oxide layer;
(7) performing ALD to deposit an aluminum oxide layer on a surface of the crystalline silicon oxide;
(8) performing PECVD to deposit a rear-side silicon nitride layer on a surface of the aluminum oxide layer;
(9) performing PECVD to deposit a front-side silicon nitride layer on a surface of the front-side silicon oxide layer; and
(10) performing screen printing and sintering to form a front-side electrode and a rear-side electrode on a front side and a rear side of the silicon plate, respectively.

Compared with the existing art, the present application includes the beneficial effects below.

The amorphous silicon oxide is mostly adopted for the silicon oxide layer in the rear passivation structure of the PERC cell. However, the amorphous silicon oxide has relatively weak silicon-hydrogen bonds and relatively poor passivation effect. In the present application, the traditional amorphous silicon oxide is replaced with the crystalline silicon oxide. The atomic distribution in the amorphous silicon oxide has a certain order, but only a short-range order, while the atomic distribution in the crystalline silicon oxide has a long-range order. Therefore, compared with the amorphous silicon oxide layer, the crystalline silicon oxide layer has a higher compactness, a better passivation effect and the interface defect density that can be as low as 10¹⁰ cm⁻²eV⁻¹, improving the overall performance of the PERC cell.

The object of the present application is further to provide a rear passivation structure of a PERC cell and a PERC cell including the same. The present application provides a sandwich-like rear passivation structure of a PERC cell. A main passivation structure is formed by a first crystalline silicon oxide layer, a gallium oxide layer and a second crystalline silicon oxide layer which are stacked in sequence. The three films are complementary to each other, thereby reducing the recombination rate of the rear surface, improving the passivation effect of the rear surface and improving the passivation effect.

To achieve this object, the present application adopts the technical solutions below.

In a fourth aspect, the present application provides a rear passivation structure of a PERC cell. The rear passivation structure of the PERC cell includes a first crystalline silicon oxide layer, a gallium oxide layer, a second crystalline silicon oxide layer and at least two rear-side silicon nitride layers which are stacked on a rear side of a silicon substrate in sequence.

The present application provides a sandwich-like rear passivation structure of a PERC cell. A main passivation structure is formed by a first crystalline silicon oxide layer, a gallium oxide layer and a second crystalline silicon oxide layer which are stacked in sequence. The three films are complementary to each other, thereby reducing the recombination rate of the rear surface, improving the passivation effect of the rear surface and improving the passivation effect. Specifically, the first crystalline silicon oxide layer is deposited on a surface of the silicon substrate to saturate dangling bonds on the silicon surface, thereby reducing the density of the interface state and providing excellent chemical passivation effect for the interface; and the gallium oxide layer is sandwiched between the first crystalline silicon oxide layer and the second crystalline silicon oxide layer, thereby forming a high concentration of fixed negative charge which has a field passivation effect on the surface of the silicon substrate, reducing the carrier recombination, effectively reducing the density of the surface state and improving the chemical passivation effect.

In addition, amorphous silicon oxide is mostly adopted for the traditional silicon oxide layer. However, the amorphous silicon oxide has relatively weak silicon-hydrogen bonds and relatively poor passivation effect. In the present application, traditional amorphous silicon oxide is replaced with crystalline silicon oxide. The atomic distribution in the amorphous silicon oxide has a certain order, but only a short-range order, while atomic distribution in the crystalline silicon oxide has a long-range order. Therefore, compared with an amorphous silicon oxide layer, a crystalline silicon oxide layer has a higher compactness, a better passivation effect and the interface defect density that can be as low as 10¹⁰ cm⁻²eV⁻¹, thereby improving the overall performance of the PERC cell.

It should be noted that the crystalline silicon oxide limited in the present application is a concept opposite to the amorphous silicon oxide. Silicon oxide has crystalline state or amorphous state. For example, crystal (quartz) is crystalline silicon oxide, while an oxide film thermally grown on a silicon wafer is amorphous silicon oxide. The atomic distribution in the crystalline silicon oxide has a long-range order, and the atomic distribution in the amorphous silicon oxide also has a certain order, but only a short-range order.

In addition, it should be noted that the rear passivation structure as claimed in the present application is part of the structure in the PERC cell, and it should be understood that, within the protection scope limited here, no specific requirements or special limitations are imposed on other structures in the PERC cell. In other words, on the basis of the rear passivation structure limited in the present application, those skilled in the art may make conventional substitutions or inventive improvements to the other structures based on the existing art.

As a preferred technical solution of the present application, a connection block is disposed at a contact surface between the silicon substrate and the first crystalline silicon oxide layer, the connection block and the first crystalline silicon oxide layer are an integrated structure, and the connection block is embedded inside the silicon substrate.

In the present application, a plurality of connection blocks are disposed at the contact surface between the silicon substrate and the first crystalline silicon oxide layer. The connection blocks are added so that a contact area between the silicon substrate and the first crystalline silicon oxide layer is increased, which enables the silicon substrate and the first crystalline silicon oxide layer to be more stable, ensures proper functioning of the cell and also ensures a service life of the cell.

As a preferred technical solution of the present application, a first fixing block is disposed at a contact surface between the first crystalline silicon oxide layer and the gallium oxide layer, the first fixing block and the gallium oxide layer are an integrated structure, and the first fixing block is embedded inside the first crystalline silicon oxide layer.

In the present application, a plurality of first fixing blocks are disposed at the contact surface between the first crystalline silicon oxide layer and the gallium oxide layer. The first fixing blocks are added so that a contact area between the first crystalline silicon oxide layer and the gallium oxide layer is increased, which enables the first crystalline silicon oxide layer and the gallium oxide layer to be more stable, ensures proper functioning of the cell and also ensures the service life of the cell.

As a preferred technical solution of the present application, a second fixing block is disposed at a contact surface between the gallium oxide layer and the second crystalline silicon oxide layer, the second fixing block and the gallium oxide layer are an integrated structure, and the second fixing block is embedded inside the second crystalline silicon oxide layer.

In the present application, a plurality of second fixing blocks are disposed at the contact surface between the gallium oxide layer and the second crystalline silicon oxide layer. The second fixing blocks are added so that a contact area between the gallium oxide layer and the second crystalline silicon oxide layer is increased, which enables the gallium oxide layer and the second crystalline silicon oxide layer to be more stable, ensures proper functioning of the cell and also ensures the service life of the cell. Optionally, both the first fixing block and the second fixing block have trapezoidal cross-section.

As a preferred technical solution of the present application, the first crystalline silicon oxide layer has a thickness of 1-10 nm, which may be, for example, 1 nm, 2 nm, 3 nm, 4 nm, 5 nm, 6 nm, 7 nm, 8 nm, 9 nm or 10 nm. However, the thickness is not limited to the listed values, and other unlisted values within this value range are also applicable.

As a preferred technical solution of the present application, the gallium oxide layer has a thickness of 5-10 nm, which may be, for example, 5 nm, 5.5 nm, 6 nm, 6.5 nm, 7 nm, 7.5 nm, 8 nm, 8.5 nm, 9 nm, 9.5 nm or 10 nm. However, the thickness is not limited to the listed values, and other unlisted values within this value range are also applicable.

As a preferred technical solution of the present application, the second crystalline silicon oxide layer has a thickness of 1-10 nm, which may be, for example, 1 nm, 2 nm, 3 nm, 4 nm, 5 nm, 6 nm, 7 nm, 8 nm, 9 nm or 10 nm. However, the thickness is not limited to the listed values, and other unlisted values within this value range are also applicable.

As a preferred technical solution of the present application, all the rear-side silicon nitride layers have a total thickness of 40-80 nm, which may be, for example, 40 nm, 45 nm, 50 nm, 55 nm, 60 nm, 65 nm, 70 nm, 75 nm or 80 nm. However, the total thickness is not limited to the listed values, and other unlisted values within this value range are also applicable.

As a preferred technical solution of the present application, thicknesses of all the rear-side silicon nitride layers decrease in gradient from inside to outside.

In a fifth aspect, the present application provides a PERC cell including the rear passivation structure of the PERC cell according to the fourth aspect, where the PERC cell includes a silicon substrate, where an emitter, a front-side silicon oxide layer and a front-side silicon nitride layer are stacked on a front side of the silicon substrate in sequence, and the rear passivation structure of the PERC cell according to the fourth aspect is disposed on a rear side of the silicon substrate.

The PERC cell further includes a front-side electrode and a rear-side electrode, where the front-side electrode is perpendicularly inserted into the silicon substrate from a front side of the PERC cell, and the rear-side electrode is perpendicularly inserted into the silicon substrate from a rear side of the PERC cell.

Exemplarily, the present application provides the preparation method below for reference by those skilled in the art, which is, however, not intended to limit the protection scope of the present application:
(1) performing texturization on a surface of a monocrystalline silicon substrate to form a textured surface, and cleaning the monocrystalline silicon substrate after texturization;
(2) performing phosphorus diffusion on the cleaned silicon substrate to generate PSG on the surface, and performing laser doping to form a localised heavily doped region on a front side of the silicon substrate to obtain a selective emitter;
(3) etching and removing the remained PSG on the surface of the silicon substrate with an HF aqueous solution.
(4) performing thermal oxidation method to deposit a front-side silicon oxide layer on a surface of the selective emitter;
(5) placing the silicon substrate in a film-forming chamber, introducing laughing gas and silane into the film-forming chamber, and performing PECVD to deposit an amorphous silicon oxide thin film on a rear side of the silicon substrate;
(6) then, performing annealing on the silicon substrate in a hydrogen-rich atmosphere, where the hydrogen-rich atmosphere is a mixed gas of nitrogen and/or an inert gas; after the annealing is completed, the amorphous silicon oxide thin film is transformed into a first crystalline silicon oxide layer;
(7) performing ALD to deposit a gallium oxide layer on a surface of the first crystalline silicon oxide;
(8) repeating steps (5) and (6), and depositing a second crystalline silicon oxide layer on a surface of the gallium oxide layer;
(9) performing PECVD to deposit at least two rear-side silicon nitride layers on a surface of the second crystalline silicon oxide layer;
(10) performing PECVD to deposit a front-side silicon nitride layer on a surface of the front-side silicon oxide layer; and
(11) performing screen printing and sintering to form a front-side electrode and a rear-side electrode on a front side and a rear side of the silicon plate, respectively.

Compared with the existing art, the present application includes the beneficial effects below.
(1) The present application provides the sandwich-like rear passivation structure of the PERC cell. The main passivation structure is formed by the first crystalline silicon oxide layer, the gallium oxide layer and the second crystalline silicon oxide layer which are stacked in sequence. The three films are complementary to each other, thereby reducing the recombination rate of the rear surface, improving the passivation effect of the rear surface and improving the passivation effect. Specifically, the first crystalline silicon oxide layer is deposited on the surface of the silicon substrate to saturate dangling bonds on the silicon surface, thereby reducing the density of the interface state and providing excellent chemical passivation effect of the interface; and the gallium oxide layer is sandwiched between the first crystalline silicon oxide layer and the second crystalline silicon oxide layer, thereby forming a high concentration of fixed negative charge which has a field passivation effect on the surface of the silicon substrate, reducing the carrier recombination, effectively reducing the density of the surface state and improving the chemical passivation effect.
(2) The amorphous silicon oxide is mostly adopted for the traditional silicon oxide layer.

However, the amorphous silicon oxide has relatively weak silicon-hydrogen bonds and relatively poor passivation effect. In the present application, the traditional amorphous silicon oxide is replaced with the crystalline silicon oxide. The atomic distribution in the amorphous silicon oxide has a certain order, but only a short-range order, while the atomic distribution in the crystalline silicon oxide has a long-range order. Therefore, compared with the amorphous silicon oxide layer, the crystalline silicon oxide layer has a higher compactness, a better passivation effect and an interface defect density that can be as low as 10¹⁰ cm⁻²eV⁻¹, thereby improving the overall performance of the PERC cell.

### BRIEF DESCRIPTION OF DRAWINGS

FIG. 1 is a structure schematic diagram of a PERC cell according to an embodiment of the present application.

### Reference list

- 1: front-side electrode
- 2: front-side silicon nitride layer
- 3: front-side silicon oxide layer
- 4: emitter
- 5: silicon substrate
- 6: crystalline silicon oxide layer
- 7: aluminum oxide layer
- 8: rear-side silicon nitride layer
- 9: rear-side electrode

FIG. 2 is a structure schematic diagram of a PERC cell according to another embodiment of the present application.

### Reference list

- 11: front-side electrode
- 12: front-side silicon nitride layer
- 13: front-side silicon oxide layer
- 14: emitter
- 15: silicon substrate
- 16: first crystalline silicon oxide layer
- 17: gallium oxide layer
- 18: second crystalline silicon oxide layer
- 19: rear-side silicon nitride layer
- 110: rear-side electrode
- 111: connection block
- 112: first fixing block
- 113: second fixing block

### DETAILED DESCRIPTION

Technical solutions of the present application are further described hereinafter with reference to the drawings and the embodiments.

### Example 1

This example provides a method for preparing a PERC cell. The preparation method includes the steps below:
(1) texturization was performed on a surface of a monocrystalline silicon substrate 5 with a mixed solution of NaOH, water and ethanol at 70 °C to form a textured surface, where a volume ratio of NaOH, water and ethanol was 8:240:3; the monocrystalline silicon substrate 5 was cleaned after texturization;
(2) phosphorus diffusion was performed on the cleaned silicon substrate 5 to generate PSG on the surface, and a localised heavily doped region was formed on a front side of the silicon substrate 5 through laser doping to obtain a selective emitter 4;
(3) the remained PSG on the surface of the silicon substrate 5 was etched away with an HF aqueous solution, where a volume ratio of water and HF in the HF aqueous solution was 35:3;
(4) a front-side silicon oxide layer 3 was deposited on a surface of the selective emitter 4 by adopting thermal oxidation method, where a flow rate of oxygen was 1000 sccm, the deposition was performed at a pressure of 100 Pa, the thermal oxidation was performed at 600 °C, and the deposition was performed for 10 min;
(5) the silicon substrate 5 was placed in a film-forming chamber, and laughing gas and silane were introduced into the film-forming chamber, where the laughing gas was introduced at a flow rate of 4000 sccm, and the silane was introduced at a flow rate of 500 sccm; a pressure in the film-forming chamber was maintained at 1400 Pa, and an amorphous silicon oxide thin film was deposited on a rear side of the silicon substrate 5 by adopting PECVD method, where the plasma had a radio frequency power of 6000 W, and the deposition was performed for 10 s;
(6) then, an annealing treatment was performed on the silicon substrate 5 in a hydrogen-rich atmosphere, where the hydrogen-rich atmosphere was a mixed gas of hydrogen and nitrogen, the hydrogen accounted for 40% of a total volume of the mixed gas, and the annealing was performed for 1 min at 850 °C; after the annealing was completed, the amorphous silicon oxide thin film was transformed into a crystalline silicon oxide layer 6;
(7) an aluminum oxide layer 7 was deposited on a surface of crystalline silicon oxide by adopting ALD; where deposition process parameters of the aluminum oxide layer 7 were a radio frequency power of 450 W, a deposition temperature of 350 °C, a deposition pressure of 10 Pa, a flow rate of TMA of 300 sccm, a flow rate of oxygen of 400 sccm, a flow rate of nitrogen of 350 sccm and a deposition time of 8 s;
(8) a rear-side silicon nitride layer 8 was deposited on a surface of the aluminum oxide layer 7 by adopting PECVD; where deposition process parameters of silicon nitride were a deposition radio frequency power of 9000 W, a deposition temperature of 450 °C, a deposition pressure of 300 Pa, a flow rate of ammonia gas of 6250 sccm, a flow rate of silane of 680 sccm and a deposition time of 800 s;
(9) a front-side silicon nitride layer 2 was deposited on a surface of the front-side silicon oxide layer 3 by adopting PECVD; deposition process parameters of silicon nitride were a deposition radio frequency power of 9000 W, a deposition temperature of 450 °C, a deposition pressure of 300 Pa, a flow rate of ammonia gas of 6250 sccm, a flow rate of silane of 680 sccm and a deposition time of 800 s; and
(10) a front-side electrode 1 and a rear-side electrode 9 were formed on a front side and a rear side of the silicon plate, respectively, by screen printing and sintering.

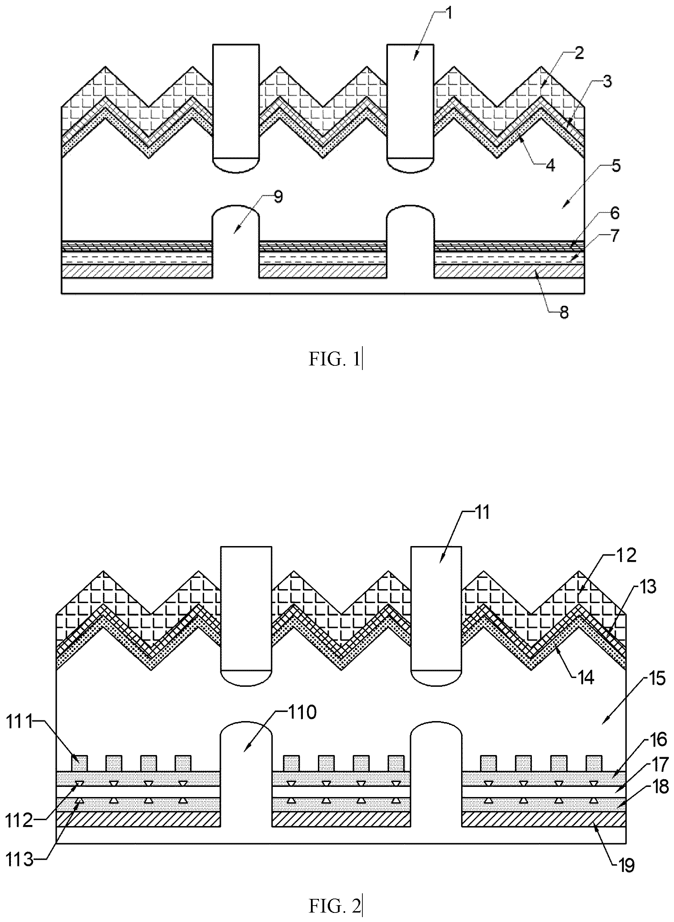

The finally prepared PERC cell, which is shown in FIG. 1, includes the silicon substrate 5, where the emitter 4, the front-side silicon oxide layer 3 and the front-side silicon nitride layer 2 are stacked on the front side of the silicon substrate 5 in sequence, the front-side silicon oxide layer 3 has a thickness of 1 nm, the front-side silicon nitride layer 2 has a thickness of 15 nm, and the front-side electrode 1 is further disposed on the front side. The crystalline silicon oxide layer 6, the aluminum oxide layer 7 and the rear-side silicon nitride layer 8 are stacked on the rear side of the silicon substrate 5 in sequence, the crystalline silicon oxide layer 6 has a thickness of 5 nm, the aluminum oxide layer 7 has a thickness of 5 nm, the rear-side silicon nitride layer 8 has a thickness of 15 nm, and the rear-side electrode 9 is further disposed on the rear side.

### Example 2

This example provides a method for preparing a PERC cell. The preparation method includes the steps below:
(1) texturization was performed on a surface of a monocrystalline silicon substrate 5 with a mixed solution of KOH, water and isopropanol at 75 °C to form a textured surface, where a volume ratio of KOH, water and isopropanol was 10:280:2.5; the monocrystalline silicon substrate 5 was cleaned after texturization;
(2) phosphorus diffusion was performed on the cleaned silicon substrate 5 to generate PSG on the surface, and a localised heavily doped region was formed on a front side of the silicon substrate 5 through laser doping to obtain a selective emitter 4;
(3) the remained PSG on the surface of the silicon substrate 5 was etched away with an HF aqueous solution, where a volume ratio of water and HF in the HF aqueous solution was 37:3;
(4) a front-side silicon oxide layer 3 was deposited on a surface of the selective emitter 4 by adopting thermal oxidation method, where a flow rate of oxygen was 1200 sccm, the deposition was performed at a pressure of 140 Pa, the thermal oxidation was performed at 620 °C, and the deposition was performed for 15 min;
(5) the silicon substrate 5 was placed in a film-forming chamber, and laughing gas and silane were introduced into the film-forming chamber, where the laughing gas was introduced at a flow rate of 4500 sccm, and the silane was introduced at a flow rate of 560 sccm; a pressure in the film-forming chamber was maintained at 1450 Pa, and an amorphous silicon oxide thin film was deposited on a rear side of the silicon substrate 5 by adopting PECVD method, where the plasma had a radio frequency power of 6800 W, and the deposition was performed for 50 s.
(6) then, an annealing treatment was performed on the silicon substrate 5 in a hydrogen-rich atmosphere, where the hydrogen-rich atmosphere was a mixed gas of nitrogen and argon, the hydrogen accounted for 50% of a total volume of the mixed gas, and the annealing was performed for 3 min at 950 °C; after the annealing was completed, the amorphous silicon oxide thin film was transformed into a crystalline silicon oxide layer 6;
(7) an aluminum oxide layer 7 was deposited on a surface of crystalline silicon oxide by adopting ALD, where deposition process parameters of the aluminum oxide layer 7 were a radio frequency power of 450 W, a deposition temperature of 370 °C, a deposition pressure of 10.4 Pa, a flow rate of TMA of 320 sccm, a flow rate of oxygen of 420 sccm, a flow rate of nitrogen of 360 sccm and a deposition time of 8.5 s;
(8) a rear-side silicon nitride layer 8 was deposited on a surface of the aluminum oxide layer 7 by adopting PECVD, where deposition process parameters of silicon nitride were a deposition radio frequency power of 9000 W, a deposition temperature of 456 °C, a deposition pressure of 250 Pa, a flow rate of ammonia gas of 6250 sccm, a flow rate of silane of 680 sccm and a deposition time of 830 s;
(9) a silicon nitride layer was deposited on a surface of the front-side silicon oxide layer 3 by adopting PECVD, where deposition process parameters of silicon nitride were a deposition radio frequency power of 9000 W, a deposition temperature of 456 °C, a deposition pressure of 250 Pa, a flow rate of ammonia gas of 6250 sccm, a flow rate of silane of 680 sccm and a deposition time of 830 s; and
(10) a front-side electrode 1 and a rear-side electrode 9 were formed on a front side and a rear side of the silicon plate, respectively, by screen printing and sintering.

The finally prepared PERC cell includes the silicon substrate 5, where the emitter 4, the front-side silicon oxide layer 3 and the front-side silicon nitride layer 2 are stacked on the front side of the silicon substrate 5 in sequence, the front-side silicon oxide layer 3 has a thickness of 3 nm, the front-side silicon nitride layer 2 has a thickness of 50 nm, and the front-side electrode 1 is further disposed on the front side. The crystalline silicon oxide layer 6, the aluminum oxide layer 7 and the rear-side silicon nitride layer 8 are stacked on the rear side of the silicon substrate 5 in sequence, the crystalline silicon oxide layer 6 has a thickness of 10 nm, the aluminum oxide layer 7 has a thickness of 8 nm, the silicon nitride layer has a thickness of 50 nm, and the rear-side electrode 9 is further disposed on the rear side.

### Example 3

This example provides a method for preparing a PERC cell. The preparation method includes the steps below:
(1) texturization was performed on a surface of a monocrystalline silicon substrate 5 with a mixed solution of NaOH, water and ethanol at 80 °C to form a textured surface, where a volume ratio of NaOH, water and ethanol was 10:330:2.2; the monocrystalline silicon substrate 5 was cleaned after texturization;
(2) phosphorus diffusion was performed on the cleaned silicon substrate 5 to generate PSG on the surface, and a localised heavily doped region was formed on a front side of the silicon substrate 5 through laser doping to obtain a selective emitter 4;
(3) the remained PSG on the surface of the silicon substrate 5 was etched away with an HF aqueous solution, where a volume ratio of water and HF in the HF aqueous solution was 40:3;
(4) a front-side silicon oxide layer 3 was deposited on a surface of the selective emitter 4 by adopting thermal oxidation method, where a flow rate of oxygen was 1400 sccm, the deposition was performed at a pressure of 180 Pa, the thermal oxidation was performed at 640 °C, and the deposition was performed for 20 min;
(5) the silicon substrate 5 was placed in a film-forming chamber, and laughing gas and silane were introduced into the film-forming chamber, where the laughing gas was introduced at a flow rate of 5000 sccm, and the silane was introduced at a flow rate of 620 sccm; a pressure in the film-forming chamber was maintained at 1500 Pa, and an amorphous silicon oxide thin film was deposited on a rear side of the silicon substrate 5 by adopting PECVD method, where the plasma had a radio frequency power of 7600 W, and the deposition was performed for 100 s;
(6) then, an annealing treatment was performed on the silicon substrate 5 in a hydrogen-rich atmosphere, where the hydrogen-rich atmosphere was a mixed gas of nitrogen and helium, the hydrogen accounted for 60% of a total volume of the mixed gas, and the annealing was performed for 5 min at 1050 °C; after the annealing was completed, the amorphous silicon oxide thin film was transformed into a crystalline silicon oxide layer 6;
(7) an aluminum oxide layer 7 was deposited on a surface of crystalline silicon oxide by adopting ALD, where deposition process parameters of the aluminum oxide layer 7 were a radio frequency power of 450 W, a deposition temperature of 400 °C, a deposition pressure of 10.8 Pa, a flow rate of TMA of 340 sccm, a flow rate of oxygen of 440 sccm, a flow rate of nitrogen of 370 sccm and a deposition time of 9 s;
(8) a rear-side silicon nitride layer 8 was deposited on a surface of the aluminum oxide layer 7 by adopting PECVD, where deposition process parameters of silicon nitride were a deposition radio frequency power of 9000 W, a deposition temperature of 462 °C, a deposition pressure of 280 Pa, a flow rate of ammonia gas of 6250 sccm, a flow rate of silane of 680 sccm and a deposition time of 860 s;
(9) a silicon nitride layer was deposited on a surface of the front-side silicon oxide layer 3 by adopting PECVD, where deposition process parameters of silicon nitride were a deposition radio frequency power of 9000 W, a deposition temperature of 462 °C, a deposition pressure of 280 Pa, a flow rate of ammonia gas of 6250 sccm, a flow rate of silane of 680 sccm and a deposition time of 860 s; and
(10) a front-side electrode 1 and a rear-side electrode 9 were formed on a front side and a rear side of the silicon plate, respectively, by screen printing and sintering.

The finally prepared PERC cell includes the silicon substrate 5, where the emitter 4, the front-side silicon oxide layer 3 and the front-side silicon nitride layer 2 are stacked on the front side of the silicon substrate 5 in sequence, the front-side silicon oxide layer 3 has a thickness of 2 nm, the front-side silicon nitride layer 2 has a thickness of 80 nm, and the front-side electrode 1 is further disposed on the front side. The crystalline silicon oxide layer 6, the aluminum oxide layer 7 and the rear-side silicon nitride layer 8 are stacked on the rear side of the silicon substrate 5 in sequence, the crystalline silicon oxide layer 6 has a thickness of 15 nm, the aluminum oxide layer 7 has a thickness of 8 nm, the silicon nitride layer has a thickness of 80 nm, and the rear-side electrode 9 is further disposed on the rear side.

### Example 4

This example provides a method for preparing a PERC cell. The preparation method includes the steps below:
(1) texturization was performed on a surface of a monocrystalline silicon substrate 5 with a mixed solution of KOH, water and isopropanol at 82 °C to form a textured surface, where a volume ratio of KOH, water and isopropanol was 11:330:2.5; the monocrystalline silicon substrate 5 was cleaned after texturization;
(2) phosphorus diffusion was performed on the cleaned silicon substrate 5 to generate PSG on the surface, and a localised heavily doped region was formed on a front side of the silicon substrate 5 through laser doping to obtain a selective emitter 4;
(3) the remained PSG on the surface of the silicon substrate 5 was etched away with an HF aqueous solution, where a volume ratio of water and HF in the HF aqueous solution was 42:3;
(4) a front-side silicon oxide layer 3 was deposited on a surface of the selective emitter 4 by adopting thermal oxidation method, where a flow rate of oxygen was 1600 sccm, the deposition was performed at a pressure of 220 Pa, the thermal oxidation was performed at 660 °C, and the deposition was performed for 22 min;
(5) the silicon substrate 5 was placed in a film-forming chamber, and laughing gas and silane were introduced into the film-forming chamber, where the laughing gas was introduced at a flow rate of 5300 sccm, and the silane was introduced at a flow rate of 680 sccm; a pressure in the film-forming chamber was maintained at 1530 Pa, and an amorphous silicon oxide thin film was deposited on a rear side of the silicon substrate 5 by adopting PECVD method, where the plasma had a radio frequency power of 8400 W, and the deposition was performed for 150 s;
(6) then, an annealing treatment was performed on the silicon substrate 5 in a hydrogen-rich atmosphere, where the hydrogen-rich atmosphere was a mixed gas of nitrogen and nitrogen, the hydrogen accounted for 65% of a total volume of the mixed gas, and the annealing was performed for 10 min at 1150 °C; after the annealing was completed, the amorphous silicon oxide thin film was transformed into a crystalline silicon oxide layer 6;
(7) an aluminum oxide layer 7 was deposited on a surface of crystalline silicon oxide by adopting ALD; where deposition process parameters of the aluminum oxide layer 7 were a radio frequency power of 450 W, a deposition temperature of 420 °C, a deposition pressure of 11.2 Pa, a flow rate of TMA of 360 sccm, a flow rate of oxygen of 460 sccm, a flow rate of nitrogen of 380 sccm and a deposition time of 9.3 s;
(8) a rear-side silicon nitride layer 8 was deposited on a surface of the aluminum oxide layer 7 by adopting PECVD; where deposition process parameters of silicon nitride were a deposition radio frequency power of 9000 W, a deposition temperature of 468 °C, a deposition pressure of 250 Pa, a flow rate of ammonia gas of 6250 sccm, a flow rate of silane of 680 sccm and a deposition time of 890 s;
(9) a silicon nitride layer was deposited on a surface of the front-side silicon oxide layer 3 by adopting PECVD; where deposition process parameters of silicon nitride were a deposition radio frequency power of 9000 W, a deposition temperature of 468 °C, a deposition pressure of 250 Pa, a flow rate of ammonia gas of 6250 sccm, a flow rate of silane of 680 sccm and a deposition time of 890 s; and
(10) a front-side electrode 1 and a rear-side electrode 9 were formed on a front side and a rear side of the silicon plate, respectively, by screen printing and sintering.

The finally prepared PERC cell includes the silicon substrate 5, where the emitter 4, the front-side silicon oxide layer 3 and the front-side silicon nitride layer 2 are stacked on the front side of the silicon substrate 5 in sequence, the front-side silicon oxide layer 3 has a thickness of 4 nm, the front-side silicon nitride layer 2 has a thickness of 100 nm, and the front-side electrode 1 is further disposed on the front side. The crystalline silicon oxide layer 6, the aluminum oxide layer 7 and the rear-side silicon nitride layer 8 are stacked on the rear side of the silicon substrate 5 in sequence, the crystalline silicon oxide layer 6 has a thickness of 16 nm, the aluminum oxide layer 7 has a thickness of 8 nm, the rear-side silicon nitride layer 8 has a thickness of 100 nm, and the rear-side electrode 9 is further disposed on the rear side.

### Example 5

This example provides a method for preparing a PERC cell. The preparation method includes the steps below:
(1) texturization was performed on a surface of a monocrystalline silicon substrate 5 with a mixed solution of NaOH, water and ethanol at 88 °C to form a textured surface, where a volume ratio of NaOH, water and ethanol was 11.5:350:2.5; the monocrystalline silicon substrate 5 was cleaned after texturization;
(2) phosphorus diffusion was performed on the cleaned silicon substrate 5 to generate PSG on the surface, and a localised heavily doped region was formed on a front side of the silicon substrate 5 through laser doping to obtain a selective emitter 4;
(3) the remained PSG on the surface of the silicon substrate 5 was etched away with an HF aqueous solution, where a volume ratio of water and HF in the HF aqueous solution was 43:3;
(4) a front-side silicon oxide layer 3 was deposited on a surface of the selective emitter 4 by adopting thermal oxidation method, where a flow rate of oxygen was 1800 sccm, the deposition was performed at a pressure of 260 Pa, the thermal oxidation was performed at 680 °C, and the deposition was performed for 26 min;
(5) the silicon substrate 5 was placed in a film-forming chamber, and laughing gas and silane were introduced into the film-forming chamber, where the laughing gas was introduced at a flow rate of 5600 sccm, and the silane was introduced at a flow rate of 720 sccm; a pressure in the film-forming chamber was maintained at 1560 Pa, and an amorphous silicon oxide thin film was deposited on a rear side of the silicon substrate 5 by adopting PECVD method, where the plasma had a radio frequency power of 9200 W, and the deposition was performed for 200 s;
(6) then, an annealing treatment was performed on the silicon substrate 5 in a hydrogen-rich atmosphere, where the hydrogen-rich atmosphere was a mixed gas of nitrogen and argon, the hydrogen accounted for 70% of a total volume of the mixed gas, and the annealing was performed for 15 min at 1250 °C; after the annealing was completed, the amorphous silicon oxide thin film was transformed into a crystalline silicon oxide layer 6;
(7) an aluminum oxide layer 7 was deposited on a surface of crystalline silicon oxide by adopting ALD; where deposition process parameters of the aluminum oxide layer 7 were a radio frequency power of 450 W, a deposition temperature of 440 °C, a deposition pressure of 11.6 Pa, a flow rate of TMA of 380 sccm, a flow rate of oxygen of 480 sccm, a flow rate of nitrogen of 390 sccm and a deposition time of 9.6 s;
(8) a rear-side silicon nitride layer 8 was deposited on a surface of the aluminum oxide layer 7 by adopting PECVD; where deposition process parameters of silicon nitride were a deposition radio frequency power of 9000 W, a deposition temperature of 475 °C, a deposition pressure of 300 Pa, a flow rate of ammonia gas of 6250 sccm, a flow rate of silane of 680 sccm and a deposition time of 920 s;
(9) a silicon nitride layer was deposited on a surface of the front-side silicon oxide layer 3 by adopting PECVD; where deposition process parameters of silicon nitride were a deposition radio frequency power of 9000 W, a deposition temperature of 475 °C, a deposition pressure of 300 Pa, a flow rate of ammonia gas of 6250 sccm, a flow rate of silane of 680 sccm and a deposition time of 920 s; and
(10) a front-side electrode 1 and a rear-side electrode 9 were formed on a front side and a rear side of the silicon plate, respectively, by screen printing and sintering.

The finally prepared PERC cell includes the silicon substrate 5, where the emitter 4, the front-side silicon oxide layer 3 and the front-side silicon nitride layer 2 are stacked on the front side of the silicon substrate 5 in sequence, the front-side silicon oxide layer 3 has a thickness of 3 nm, the front-side silicon nitride layer 2 has a thickness of 150 nm, and the front-side electrode 1 is further disposed on the front side. The crystalline silicon oxide layer 6, the aluminum oxide layer 7 and the rear-side silicon nitride layer 8 are stacked on the rear side of the silicon substrate 5 in sequence, the crystalline silicon oxide layer 6 has a thickness of 18 nm, the aluminum oxide layer 7 has a thickness of 10 nm, the rear-side silicon nitride layer 8 has a thickness of 18 nm, and the rear-side electrode 9 is further disposed on the rear side.

### Example 6

This example provides a method for preparing a PERC cell. The preparation method includes the steps below:
(1) texturization was performed on a surface of a monocrystalline silicon substrate 5 with a mixed solution of KOH, water and isopropanol at 90 °C to form a textured surface, where a volume ratio of KOH, water and isopropanol was 12:360:3; the monocrystalline silicon substrate 5 was cleaned after texturization;
(2) phosphorus diffusion was performed on the cleaned silicon substrate 5 to generate PSG on the surface, and a localised heavily doped region was formed on a front side of the silicon substrate 5 through laser doping to obtain a selective emitter 4;
(3) the remained PSG on the surface of the silicon substrate 5 was etched away with an HF aqueous solution, where a volume ratio of water and HF in the HF aqueous solution was 45:3;
(4) a front-side silicon oxide layer 3 was deposited on a surface of the selective emitter 4 by adopting thermal oxidation method, where a flow rate of oxygen was 2000 sccm, the deposition was performed at a pressure of 300 Pa, the thermal oxidation was performed at 700 °C, and the deposition was performed for 30 min;
(5) the silicon substrate 5 was placed in a film-forming chamber, and laughing gas and silane were introduced into the film-forming chamber, where the laughing gas was introduced at a flow rate of 6000 sccm, and the silane was introduced at a flow rate of 800 sccm; a pressure in the film-forming chamber was maintained at 1600 Pa, and an amorphous silicon oxide thin film was deposited on a rear side of the silicon substrate 5 by adopting PECVD method, where the plasma had a radio frequency power of 10000 W, and the deposition was performed for 300 s;
(6) then, an annealing treatment was performed on the silicon substrate 5 in a hydrogen-rich atmosphere, where the hydrogen-rich atmosphere was a mixed gas of nitrogen and helium, the hydrogen accounted for 80% of a total volume of the mixed gas, and the annealing was performed for 20 min at 1300 °C; after the annealing was completed, the amorphous silicon oxide thin film was transformed into a crystalline silicon oxide layer 6;
(7) an aluminum oxide layer 7 was deposited on a surface of crystalline silicon oxide by adopting ALD; where deposition process parameters of the aluminum oxide layer 7 were a radio frequency power of 450 W, a deposition temperature of 450 °C, a deposition pressure of 12 Pa, a flow rate of TMA of 400 sccm, a flow rate of oxygen of 500 sccm, a flow rate of nitrogen of 400 sccm and a deposition time of 10 s;
(8) a rear-side silicon nitride layer 8 was deposited on a surface of the aluminum oxide layer 7 by adopting PECVD; where deposition process parameters of silicon nitride were a deposition radio frequency power of 9000 W, a deposition temperature of 480 °C, a deposition pressure of 200 Pa, a flow rate of ammonia gas of 6250 sccm, a flow rate of silane of 680 sccm and a deposition time of 950 s;
(9) a silicon nitride layer was deposited on a surface of the front-side silicon oxide layer 3 by adopting PECVD; where deposition process parameters of silicon nitride were a deposition radio frequency power of 9000 W, a deposition temperature of 480 °C, a deposition pressure of 200 Pa, a flow rate of ammonia gas of 6250 sccm, a flow rate of silane of 680 sccm and a deposition time of 950 s; and
(10) a front-side electrode 1 and a rear-side electrode 9 were formed on a front side and a rear side of the silicon plate, respectively, by screen printing and sintering.

The finally prepared PERC cell includes the silicon substrate 5, where the emitter 4, the front-side silicon oxide layer 3 and the front-side silicon nitride layer 2 are stacked on the front side of the silicon substrate 5 in sequence, the front-side silicon oxide layer 3 has a thickness of 5 nm, the front-side silicon nitride layer 2 has a thickness of 200 nm, and the front-side electrode 1 is further disposed on the front side. The crystalline silicon oxide layer 6, the aluminum oxide layer 7 and the rear-side silicon nitride layer 8 are stacked on the rear side of the silicon substrate 5 in sequence, the crystalline silicon oxide layer 6 has a thickness of 20 nm, the aluminum oxide layer 7 has a thickness of 10 nm, the rear-side silicon nitride layer 8 has a thickness of 200 nm, and the rear-side electrode 9 is further disposed on the rear side.

### Example 7

This example provides a method for preparing a PERC cell. The method differs from Example 3 in that an annealing temperature in step (6) was adjusted to 800 °C, and other process parameters and operation steps were exactly the same as those in Example 3.

### Example 8

This example provides a method for preparing a PERC cell. The method differs from Example 3 in that an annealing temperature in step (6) was adjusted to 1400 °C, and other process parameters and operation steps were exactly the same as those in Example 3.

### Comparative Example 1

This example provides a method for preparing a PERC cell. The preparation method includes the steps below:
(1) texturization was performed on a surface of a monocrystalline silicon substrate 5 with a mixed solution of NaOH, water and ethanol at 80 °C to form a textured surface, where a volume ratio of NaOH, water and ethanol was 10:330:2.2; the monocrystalline silicon substrate 5 was cleaned after texturization;
(2) phosphorus diffusion was performed on the cleaned silicon substrate 5 to generate PSG on the surface, and a localised heavily doped region was formed on a front side of the silicon substrate 5 through laser doping to obtain a selective emitter 4;
(3) the remained PSG on the surface of the silicon substrate 5 was etched away with an HF aqueous solution, where a volume ratio of water and HF in the HF aqueous solution was 40:3;
(4) a front-side silicon oxide layer 3 was deposited on a surface of the selective emitter 4 by adopting thermal oxidation method, where a flow rate of oxygen was 1400 sccm, the deposition was performed at a pressure of 180 Pa, the thermal oxidation was performed at 640 °C, and the deposition was performed for 20 min;
(5) a crystalline silicon oxide layer 6 was deposited on a rear side of the silicon substrate 5 by adopting the thermal oxidation method, where a flow rate of oxygen was 1400 sccm, the deposition was performed at a pressure of 180 Pa, the thermal oxidation was performed at 640 °C, and the deposition was performed for 20 min;
(6) an aluminum oxide layer 7 was deposited on a surface of crystalline silicon oxide by adopting ALD; where deposition process parameters of the aluminum oxide layer 7 were a radio frequency power of 450 W, a deposition temperature of 400 °C, a deposition pressure of 10.8 Pa, a flow rate of TMA of 340 sccm, a flow rate of oxygen of 440 sccm, a flow rate of nitrogen of 370 sccm and a deposition time of 9 s;
(7) a rear-side silicon nitride layer 8 was deposited on a surface of the aluminum oxide layer 7 by adopting PECVD; where deposition process parameters of silicon nitride were a deposition radio frequency power of 9000 W, a deposition temperature of 462 °C, a deposition pressure of 280 Pa, a flow rate of ammonia gas of 6250 sccm, a flow rate of silane of 680 sccm and a deposition time of 860 s;
(8) a silicon nitride layer was deposited on a surface of the front-side silicon oxide layer 3 by adopting PECVD; where deposition process parameters of silicon nitride were a deposition radio frequency power of 9000 W, a deposition temperature of 462 °C, a deposition pressure of 280 Pa, a flow rate of ammonia gas of 6250 sccm, a flow rate of silane of 680 sccm and a deposition time of 860 s; and
(9) a front-side electrode 1 and a rear-side electrode 9 were formed on a front side and a rear side of the silicon plate, respectively, by screen printing and sintering.

The finally prepared PERC cell includes the silicon substrate 5, where the emitter 4, the front-side silicon oxide layer 3 and the front-side silicon nitride layer 2 are stacked on the front side of the silicon substrate 5 in sequence, the front-side silicon oxide layer 3 has a thickness of 2 nm, the front-side silicon nitride layer 2 has a thickness of 80 nm, and the front-side electrode 1 is further disposed on the front side. The rear-side silicon oxide layer, the aluminum oxide layer 7 and the rear-side silicon nitride layer 8 are stacked on the rear side of the silicon substrate 5 in sequence, the rear-side silicon oxide layer has a thickness of 2 nm, the aluminum oxide layer 7 has a thickness of 8 nm, the silicon nitride layer has a thickness of 80 nm, and the rear-side electrode 9 is further disposed on the rear side.

### Comparative Example 2

This example provides a method for preparing a PERC cell. The preparation method includes the steps below:
(1) texturization was performed on a surface of a monocrystalline silicon substrate 5 with a mixed solution of NaOH, water and ethanol at 80 °C to form a textured surface, where a volume ratio of NaOH, water and ethanol was 10:330:2.2; the monocrystalline silicon substrate 5 was cleaned after texturization;
(2) phosphorus diffusion was performed on the cleaned silicon substrate 5 to generate PSG on the surface, and a localised heavily doped region was formed on a front side of the silicon substrate 5 through laser doping to obtain a selective emitter 4;
(3) the remained PSG on the surface of the silicon substrate 5 was etched away with an HF aqueous solution, where a volume ratio of water and HF in the HF aqueous solution was 40:3;
(4) a front-side silicon oxide layer 3 was deposited on a surface of the selective emitter 4 by adopting thermal oxidation method, where a flow rate of oxygen was 1400 sccm, the deposition was performed at a pressure of 180 Pa, the thermal oxidation was performed at 640 °C, and the deposition was performed for 20 min;
(5) the silicon substrate 5 was placed in a film-forming chamber, and laughing gas and silane were introduced into the film-forming chamber, where the laughing gas was introduced at a flow rate of 5000 sccm, and the silane was introduced at a flow rate of 620 sccm; a pressure in the film-forming chamber was maintained at 1500 Pa, and an amorphous silicon oxide layer was deposited on a rear side of the silicon substrate 5 by adopting PECVD method, where the plasma had a radio frequency power of 7600 W, and the deposition was performed for 100 s;
(7) an aluminum oxide layer 7 was deposited on a surface of the amorphous silicon oxide layer by adopting ALD; where deposition process parameters of the aluminum oxide layer 7 were a radio frequency power of 450 W, a deposition temperature of 400 °C, a deposition pressure of 10.8 Pa, a flow rate of TMA of 340 sccm, a flow rate of oxygen of 440 sccm, a flow rate of nitrogen of 370 sccm and a deposition time of 9 s;
(8) a rear-side silicon nitride layer 8 was deposited on a surface of the aluminum oxide layer 7 by adopting PECVD; where deposition process parameters of silicon nitride were a deposition radio frequency power of 9000 W, a deposition temperature of 462 °C, a deposition pressure of 280 Pa, a flow rate of ammonia gas of 6250 sccm, a flow rate of silane of 680 sccm and a deposition time of 860 s;
(9) a silicon nitride layer was deposited on a surface of the front-side silicon oxide layer 3 by adopting PECVD; where deposition process parameters of silicon nitride were a deposition radio frequency power of 9000 W, a deposition temperature of 462 °C, a deposition pressure of 280 Pa, a flow rate of ammonia gas of 6250 sccm, a flow rate of silane of 680 sccm and a deposition time of 860 s; and
(10) a front-side electrode 1 and a rear-side electrode 9 were formed on a front side and a rear side of the silicon plate, respectively, by screen printing and sintering.

The finally prepared PERC cell includes the silicon substrate 5, where the emitter 4, the front-side silicon oxide layer 3 and the front-side silicon nitride layer 2 are stacked on the front side of the silicon substrate 5 in sequence, the front-side silicon oxide layer 3 has a thickness of 15 nm, the front-side silicon nitride layer 2 has a thickness of 80 nm, and the front-side electrode 1 is further disposed on the front side. The crystalline silicon oxide layer 6, the aluminum oxide layer 7 and the rear-side silicon nitride layer 8 are stacked on the rear side of the silicon substrate 5 in sequence, the crystalline silicon oxide layer 6 has a thickness of 15 nm, the aluminum oxide layer 7 has a thickness of 8 nm, the silicon nitride layer has a thickness of 80 nm, and the rear-side electrode 9 is further disposed on the rear side.

The open-circuit voltage (Uoc), short-circuit current (Isc), fill factor (FF), photoelectric conversion efficiency (Eta) and interface defect density (Dit) of the PERC cells provided in Examples 1 to 8 and Comparative Examples 1 and 2 were measured. The results are shown in Table 1. It should be noted that the defect density of the interface between a silicon substrate and a passivation layer is a key factor to measure a passivation effect. The lower the defect density, the more excellent the passivation effect.

**Table 1**

| | Interface Defect Density Dit (10¹⁰cm⁻²eV⁻¹) |
|---|---|
| Example 1 | 1.0 |
| Example 2 | 1.2 |
| Example 3 | 1.2 |
| Example 4 | 1.1 |
| Example 5 | 1.0 |
| Example 6 | 1.0 |
| Example 7 | 1.3 |
| Example 8 | 1.4 |
| Comparative Example 1 | 1.5 |
| Comparative Example 2 | 5.0 |

**Table 2**

| No. | Uoc (V) | Isc (A) | FF (%) | Eta (%) |
|---|---|---|---|---|
| Example 1 | 0.696 | 11.195 | 81.28 | 23.10 |
| Example 2 | 0.695 | 11.196 | 81.09 | 23.05 |
| Example 3 | 0.696 | 11.196 | 81.10 | 23.05 |
| Example 4 | 0.696 | 11.197 | 81.12 | 23.06 |
| Example 5 | 0.697 | 11.198 | 81.14 | 23.10 |
| Example 6 | 0.697 | 11.196 | 81.18 | 23.08 |
| Example 7 | 0.697 | 11.198 | 81.05 | 23.02 |
| Example 8 | 0.696 | 11.197 | 81.03 | 23.01 |
| Comparative Example 1 | 0.695 | 11.197 | 80.69 | 22.90 |
| Comparative Example 2 | 0.692 | 11.196 | 80.53 | 22.76 |

The two points below can be seen according to Examples 3, 7 and 8 and Comparative Examples 1 and 2 in conjunction with the data in Table 1.
(1) The interface defect density of Example 3 is slightly lower than that of Comparative Example 1, indicating that the passivation effect of Example 3 is superior to that of Comparative Example 1. The reason is that only the thermal oxidation method is used for preparing silicon oxide in Comparative Example 1, while a combination of the PECVD and the thermal oxidation method is used for preparing silicon oxide in Example 3. Although the products of crystalline silicon oxide are obtained in both Example 3 and Comparative Example 1, the thickness of the silicon oxide layer prepared in Comparative Example 1 is much less than that in Example 3 (the crystalline silicon oxide layer 6 in Comparative Example 1 has a thickness of 2 nm, and the crystalline silicon oxide layer 6 in Example 3 has a thickness of 15 nm), resulting in that the passivation effect of Comparative Example 1 is inferior to that of Example 3.
(2) The interface defect density of Example 3 is much lower than that of Comparative Example 2, indicating that the passivation effect of Example 3 is much better than that of Comparative Example 2. The reason is that what is prepared in Example 3 through the combination of the PECVD and the thermal oxidation method is crystalline silicon oxide, while what is prepared in Comparative Example 2 only through the PECVD is amorphous silicon oxide, and the passivation effect of the crystalline silicon oxide is superior to that of the amorphous silicon oxide.
(3) The measurements of Examples 7 and 8 are both slightly less than that of Example 3. The reason is that the passivation effect of the prepared crystalline silicon oxide layer 6 is affected by the too high or too low annealing temperature.

As can be seen from the above, in the present application, the silicon oxide is prepared through the combination of the PECVD and the thermal oxidation method, the thickness defect of the thermal oxidation method is compensated by the PECVD, the amorphous defect of the PECVD is compensated by the thermal oxidation method, and a relatively thick crystalline silicon oxide layer 6 is finally obtained through the combination of the PECVD and the thermal oxidation method.

As can be seen from Table 2, the improvement in the passivation effect also improves the overall performance of the PERC cell.

In an embodiment, the present application provides a rear passivation structure of a PERC cell.

The rear passivation structure of the PERC cell, which is shown in FIG. 2, includes a first crystalline silicon oxide layer 16, a gallium oxide layer 17, a second crystalline silicon oxide layer 18 and at least two rear-side silicon nitride layers 19 which are stacked on a rear side of a silicon substrate 15 in sequence. The first crystalline silicon oxide layer 16 has a thickness of 1-10 nm, the gallium oxide layer 17 has a thickness of 5-10 nm, the second crystalline silicon oxide layer 18 has a thickness of 1-10 nm, all the at least two rear-side silicon nitride layers 19 have a total thickness of 40-80 nm, and thicknesses of all the rear-side silicon nitride layers 19 decrease in gradient from inside to outside.

A connection block 111 is disposed at a contact surface between the silicon substrate 15 and the first crystalline silicon oxide layer 16, the connection block 111 and the first crystalline silicon oxide layer 16 are an integrated structure, and the connection block 111 is embedded inside the silicon substrate 15. A first fixing block 112 is disposed at a contact surface between the first crystalline silicon oxide layer 16 and the gallium oxide layer 17, the first fixing block 112 and the gallium oxide layer 17 are an integrated structure, and the first fixing block 112 is embedded inside the first crystalline silicon oxide layer 16. A second fixing block 113 is disposed at a contact surface between the gallium oxide layer 17 and the second crystalline silicon oxide layer 18, the second fixing block 113 and the gallium oxide layer 17 are an integrated structure, and the second fixing block 113 is embedded inside the second crystalline silicon oxide layer 18.

In another embodiment, the present application provides a PERC cell. The PERC cell, which is shown in FIG. 2, includes a silicon substrate 15, where an emitter 14, a front-side silicon oxide layer 13 and a front-side silicon nitride layer 12 are stacked on a front side of the silicon substrate 15 in sequence, and the rear passivation structure of the PERC cell according to the preceding embodiment is disposed on the rear side of the silicon substrate 15.

The PERC cell further includes a front-side electrode 11 and a rear-side electrode 110, where the front-side electrode 11 is perpendicularly inserted into the silicon substrate 15 from a front side of the PERC cell, and the rear-side electrode 110 is perpendicularly inserted into the silicon substrate 15 from a rear side of the PERC cell.

### Example 1'

This example provides a PERC cell, which is based on the PERC cell provided in an embodiment, wherein the first crystalline silicon oxide layer 16 had a thickness of 1 nm, the gallium oxide layer 17 had a thickness of 5 nm, and the second silicon oxide layer had a thickness of 1 nm. There were two rear-side silicon nitride layers 19 in total, which were denoted as a first rear-side silicon nitride layer and a second rear-side silicon nitride layer, respectively. The first rear-side silicon nitride layer had a thickness of 15 nm, and the second rear-side silicon nitride layer had a thickness of 25 nm.

### Example 2'

This example provides a PERC cell, which is based on the PERC cell provided in an embodiment, wherein the first crystalline silicon oxide layer 16 had a thickness of 3 nm, the gallium oxide layer 17 had a thickness of 6 nm, and the second crystalline silicon oxide layer 18 had a thickness of 3 nm. There were two rear-side silicon nitride layers 19 in total, which were denoted as a first rear-side silicon nitride layer and a second rear-side silicon nitride layer, respectively. The first rear-side silicon nitride layer had a thickness of 20 nm, and the second rear-side silicon nitride layer had a thickness of 30 nm.

### Example 3'

This example provides a PERC cell, which is based on the PERC cell provided in an embodiment, wherein the first crystalline silicon oxide layer 16 had a thickness of 5 nm, the gallium oxide layer 17 had a thickness of 7 nm, and the second crystalline silicon oxide layer 18 had a thickness of 5 nm. There were three rear-side silicon nitride layers 19 in total, which were denoted as a first rear-side silicon nitride layer, a second rear-side silicon nitride layer and a third rear-side silicon nitride layer, respectively. The first rear-side silicon nitride layer had a thickness of 10 nm, the second rear-side silicon nitride layer had a thickness of 20 nm, and the third rear-side silicon nitride layer had a thickness of 30 nm.

### Example 4'

This example provides a PERC cell, which is based on the PERC cell provided in an embodiment, wherein the first crystalline silicon oxide layer 16 had a thickness of 7 nm, the gallium oxide layer 17 had a thickness of 8 nm, and the second crystalline silicon oxide layer 18 had a thickness of 7 nm. There were two rear-side silicon nitride layers 19 in total, which were denoted as a first rear-side silicon nitride layer, a second rear-side silicon nitride layer and a third rear-side silicon nitride layer, respectively. The first rear-side silicon nitride layer had a thickness of 15 nm, the second rear-side silicon nitride layer had a thickness of 25 nm, and the third rear-side silicon nitride layer had a thickness of 30 nm.

### Example 5'

This example provides a PERC cell, which is based on the PERC cell provided in an embodiment, wherein the first crystalline silicon oxide layer 16 had a thickness of 9 nm, the gallium oxide layer 17 had a thickness of 9 nm, and the second crystalline silicon oxide layer 18 had a thickness of 9 nm. There were four rear-side silicon nitride layers 19 in total, which were denoted as a first rear-side silicon nitride layer, a second rear-side silicon nitride layer, a third rear-side silicon nitride layer and a fourth rear-side silicon nitride layer, respectively. The first rear-side silicon nitride layer had a thickness of 5 nm, the second rear-side silicon nitride layer had a thickness of 10 nm, the third rear-side silicon nitride layer had a thickness of 20 nm, and the fourth rear-side silicon nitride layer had a thickness of 30 nm.

### Example 6'

This example provides a PERC cell, which is based on the PERC cell provided in an embodiment, wherein the first crystalline silicon oxide layer 16 had a thickness of 10 nm, the gallium oxide layer 17 had a thickness of 10 nm, and the second crystalline silicon oxide layer 18 had a thickness of 10 nm. There were four rear-side silicon nitride layers 19 in total, which were denoted as a first rear-side silicon nitride layer, a second rear-side silicon nitride layer, a third rear-side silicon nitride layer and a fourth rear-side silicon nitride layer, respectively. The first rear-side silicon nitride layer had a thickness of 10 nm, the second rear-side silicon nitride layer had a thickness of 15 nm, the third rear-side silicon nitride layer had a thickness of 25 nm, and the fourth rear-side silicon nitride layer had a thickness of 30 nm.

### Example 7'

This example provides a method for preparing the PERC cell according to Example 3'. The preparation method includes the steps below:
(1) texturization was performed on a surface of the monocrystalline silicon substrate 15 with a mixed solution of NaOH, water and ethanol at 80 °C to form a textured surface, where a volume ratio of NaOH, water and ethanol was 10:330:2.2; the monocrystalline silicon substrate 15 was cleaned after texturization;
(2) phosphorus diffusion was performed on the cleaned silicon substrate 15 to generate PSG on the surface, and a localised heavily doped region was formed on the front side of the silicon substrate 15 through laser doping to obtain the selective emitter 14;
(3) the remained PSG on the surface of the silicon substrate 15 was etched away with an HF aqueous solution, where a volume ratio of water and HF in the HF aqueous solution was 40:3;
(4) the front-side silicon oxide layer 13 was deposited on a surface of the selective emitter 14 by adopting thermal oxidation method;
(5) the silicon substrate 15 was placed in a film-forming chamber, and laughing gas and silane were introduced into the film-forming chamber, where the laughing gas was introduced at a flow rate of 5000 sccm and the silane was introduced at a flow rate of 620 sccm; a pressure in the film-forming chamber was maintained at 1500 Pa, and an amorphous silicon oxide thin film was deposited on the rear side of the silicon substrate 15 by adopting PECVD method, where the plasma had a radio frequency power of 7600 W, and the deposition was performed for 100 s;
(6) then, an annealing treatment was performed on the silicon substrate 15 in a hydrogen-rich atmosphere, where the hydrogen-rich atmosphere was a mixed gas of nitrogen and helium, the hydrogen accounted for 60% of a total volume of the mixed gas, and the annealing was performed for 5 min at 1050 °C; after the annealing was completed, the amorphous silicon oxide thin film was transformed into the first crystalline silicon oxide layer 16 with a thickness of 5 nm;
(7) the gallium oxide layer 17 with a thickness of 7 nm was deposited on a surface of the first crystalline silicon oxide layer 16 by adopting ALD;
(8) steps (5) and (6) were repeated so that the second crystalline silicon oxide layer 18 with a thickness of 5 nm was deposited on a surface of the gallium oxide layer 17;
(9) the first rear-side silicon nitride layer, the second rear-side silicon nitride layer and the third rear-side silicon nitride layer were deposited on a surface of the second crystalline silicon oxide layer 18 in sequence by adopting PECVD;
(10) the front-side silicon nitride layer 12 was deposited on a surface of the front-side silicon oxide layer 13 by adopting PECVD; and
(11) the front-side electrode 11 and the rear-side electrode 110 were formed on a front side and a rear side of the silicon plate, respectively, by screen printing and sintering.

The applicant states that the above are only the embodiments of the present application and not intended to limit the protection scope of the present application. Those skilled in the art should understand that any changes or substitutions, which are obvious to those skilled in the art within the technical scope disclosed in the present application, shall fall within the protection scope and the disclosed scope of the present application.

The applicant states that the above are only the embodiments of the present application and not intended to limit the protection scope of the present application.

## Claims

1. A rear passivation structure of the PERC cell, comprising a crystalline silicon oxide layer disposed on a rear side of a silicon substrate.

2. The rear passivation structure of the PERC cell according to claim 1, wherein the crystalline silicon oxide layer has a thickness of 1-20 nm.

3. The rear passivation structure of the PERC cell according to claim 1, wherein an aluminum oxide layer and a rear-side silicon nitride layer are stacked on a surface of the crystalline silicon oxide layer in sequence;
the aluminum oxide layer has a thickness of 5-10 nm;
the rear-side silicon nitride layer has a thickness of 10-200 nm.

4. A method for preparing the rear passivation structure of the PERC cell according to any one of claims 1 to 3, wherein the preparation method comprises:
depositing an amorphous silicon oxide thin film on the rear side of the silicon substrate, and performing an annealing treatment to transform the amorphous silicon oxide thin film into the crystalline silicon oxide layer.

5. The preparation method according to claim 4, wherein the deposition process of the amorphous silicon oxide thin film specifically comprises:
placing the silicon substrate in a film-forming chamber, introducing laughing gas and silane into the film-forming chamber, and with a pressure maintained in the film-forming chamber, performing plasma-enhanced chemical vapor deposition to deposit the amorphous silicon oxide thin film on the rear side of the silicon substrate.

6. The preparation method according to claim 5, wherein the laughing gas is introduced at a flow rate of 4000-6000 sccm;
the silane is introduced at a flow rate of 500-800 sccm;
the pressure in the film-forming chamber is maintained at 1400-1600 Pa;
the plasma has a radio frequency power of 6000-10000 W;
the deposition is performed for 10-300 s.

7. The preparation method according to claim 4, wherein the annealing process is performed in a hydrogen-rich atmosphere;
the hydrogen-rich atmosphere is a mixed gas comprising hydrogen, wherein the hydrogen accounts for 40-80% of a total volume of the mixed gas;
the mixed gas further comprises nitrogen and/or an inert gas.

8. The preparation method according to claim 7, wherein the annealing is performed at 850-1300 °C;
the annealing is performed for 1-20 min.

9. The preparation method according to claim 4, further comprising: depositing an aluminum oxide layer and a rear-side silicon nitride layer on a surface of the crystalline silicon oxide layer in sequence.

10. A PERC cell comprising the rear passivation structure of the PERC cell according to any one of claims 1 to 3, wherein the PERC cell comprises a silicon substrate, wherein an emitter, a front-side silicon oxide layer and a front-side silicon nitride layer are stacked on a front side of the silicon substrate in sequence, and the rear passivation structure of the PERC cell according to any one of claims 1 to 3 is disposed on a rear side of the silicon substrate;
the PERC cell further comprises a front-side electrode and a rear-side electrode, wherein the front-side electrode is perpendicularly inserted into the silicon substrate from a front side of the PERC cell, and the rear-side electrode is perpendicularly inserted into the silicon substrate from a rear side of the PERC cell.

11. A rear passivation structure of the PERC cell comprising a first crystalline silicon oxide layer, a gallium oxide layer, a second crystalline silicon oxide layer and at least two rear-side silicon nitride layers which are stacked on a rear side of a silicon substrate in sequence.

12. The rear passivation structure of the PERC cell according to claim 11, wherein a connection block is disposed at a contact surface between the silicon substrate and the first crystalline silicon oxide layer, the connection block and the first crystalline silicon oxide layer are an integrated structure, and the connection block is embedded inside the silicon substrate.

13. The rear passivation structure of the PERC cell according to claim 11, wherein a first fixing block is disposed at a contact surface between the first crystalline silicon oxide layer and the gallium oxide layer, the first fixing block and the gallium oxide layer are an integrated structure, and the first fixing block is embedded inside the first crystalline silicon oxide layer.

14. The rear passivation structure of the PERC cell according to claim 11, wherein a second fixing block is disposed at a contact surface between the gallium oxide layer and the second crystalline silicon oxide layer, the second fixing block and the gallium oxide layer are an integrated structure, and the second fixing block is embedded inside the second crystalline silicon oxide layer.

15. The rear passivation structure of the PERC cell according to claim 11, wherein the first crystalline silicon oxide layer has a thickness of 1-10 nm.

16. The rear passivation structure of the PERC cell according to claim 11, wherein the gallium oxide layer has a thickness of 5-10 nm.

17. The rear passivation structure of the PERC cell according to claim 11, wherein the second crystalline silicon oxide layer has a thickness of 1-10 nm.

18. The rear passivation structure of the PERC cell according to claim 11, wherein all the rear-side silicon nitride layers have a total thickness of 40-80 nm.

19. The rear passivation structure of the PERC cell according to claim 1, wherein thicknesses of all the rear-side silicon nitride layers decrease in gradient from inside to outside.

20. A PERC cell comprising the rear passivation structure of the PERC cell according to any one of claims 11 to 19, wherein the PERC cell comprises a silicon substrate, wherein an emitter, a front-side silicon oxide layer and a front-side silicon nitride layer are stacked on a front side of the silicon substrate in sequence, and the rear passivation structure of the PERC cell according to any one of claims 11 to 19 is disposed on a rear side of the silicon substrate;
the PERC cell further comprises a front-side electrode and a rear-side electrode, wherein the front-side electrode is perpendicularly inserted into the silicon substrate from a front side of the PERC cell, and the rear-side electrode is perpendicularly inserted into the silicon substrate from a rear side of the PERC cell.
